# EUROPÄISCHE PATENTSCHRIFT

(11) **EP 1 881 894 B1**
(45) Veröffentlichungstag und Bekanntmachung des Hinweises auf die Patenterteilung: **26.09.2012**
(21) Anmeldenummer: 06792450.6
(22) Anmeldetag: 06.04.2006
(51) Int. Cl.: B32B 27/08, B32B 27/32, B65G 15/30, B29D 29/06, C09J 7/02, H05K 13/02

(54) **HAFTFOLIE**
ADHESIVE FILM
FEUILLE ADHÉSIVE

(30) Priorität: 20.05.2005 DE 102005023280
(43) Veröffentlichungstag der Anmeldung: 30.01.2008
(73) Patentinhaber: Pütz GmbH + Co. Folien KG, 65232 Taunusstein-Wehen (DE)
(72) Erfinder: ERDMANN, Ralph, 65205 Wiesbaden (DE)
(74) Vertreter: WSL Patentanwälte Partnerschaftsgesellschaft
(86) Internationale Anmeldenummer: PCT/EP2006/061411
(87) Internationale Veröffentlichungsnummer: WO 2006/122853

(56) Entgegenhaltungen:
- EP-A- 0 578 979
- EP-A- 0 708 586
- DE-A1- 3 127 120
- DE-A1- 10 111 038
- US-A- 4 927 709
- PATENT ABSTRACTS OF JAPAN Bd. 2002, Nr. 06, 4. Juni 2002 (2002-06-04) & JP 2002 046834 A (NIPPON JIIKURINGU KK), 12. Februar 2002 (2002-02-12)
- PATENT ABSTRACTS OF JAPAN Bd. 2003, Nr. 12, 5. Dezember 2003 (2003-12-05) & JP 2004 136568 A (NEWLONG SEIMITSU KOGYO CO LTD), 13. Mai 2004 (2004-05-13)

## Beschreibung

Die vorliegende Erfindung betrifft eine Haftfolie zum lösbaren Halten von Gegenständen. Des weiteren betrifft die Erfindung ein Transportband zum Transportieren von Gegenständen, wobei die Gegenstände lösbar mit dem Transportband verbunden oder verbindbar sind, und wobei das Transportband eine Haftfolie aufweist.

Bei vielen industriellen Fertigungsprozessen kommt es insbesondere darauf an, in möglichst kurzer Zeit eine möglichst große Stückzahl der Endprodukte des jeweiligen Fertigungsprozesses zu erzielen, da durch eine höhere Produktivität pro Zeiteinheit insbesondere Produktionskosten eingespart werden können. Üblicherweise werden bei automatisierten Fertigungsprozessen entlang einer Produktionsstrecke die verschiedenen Einzelkomponenten eines Endprodukts zunächst zusammengeführt und anschließend miteinander verarbeitet und/oder zusammengefügt. Sowohl das auf diese Weise allmählich entstehende Produkt als auch die für die Produktentstehung erforderlichen Komponenten müssen im Sinne der eingangs geforderten Effektivität mit hohen Geschwindigkeiten zu der bzw. durch die Produktionsstrecke transportiert werden. Zu diesem Zweck gibt es verschiedene Transportmechanismen, von denen das Fließband am bekanntesten ist. Bei einigen Fließbändern tritt das Fließband zwar in Kontakt mit dem zu transportierenden Gegenstand, allerdings ohne daß eine zumindest vorübergehend feste Verbindung zwischen Band und Transportgegenstand ausgebildet wird. Dagegen werden bei anderen Fließbandtypen die Transportgegenstände vom Fließband bzw. von darauf befestigten Mechanismen gehalten, indem eine vorübergehende feste Verbindung ausgebildet wird. Bei einigen Fließbandausführungen wird diese Verbindung mit dem zu transportierenden Gegenstand über ein Haft- oder Klebemittel ausgebildet. Als Haft- oder Klebemittel kommen Stoffe in Betracht, an die folgende Anforderungen zu stellen sind. Diese Stoffe müssen erstens sowohl mit dem Fließ- bzw. Transportband als auch mit dem Transportgegenstand so fest verbindbar sein, daß der Transportgegenstand am Transportband festgehalten ist und sich nicht spontan vom Band lösen kann. Die Verbindung zwischen Transportband und Transportgegenstand muß zweitens jedoch wieder lösbar sein, nämlich genau in dem Moment, in dem der Transportgegenstand seinen Bestimmungsort, also den Ort, an dem der Gegenstand verarbeitet werden soll, erreicht hat. Drittens muß die Verbindung zwischen Transportband und Haft- oder Klebemittel so ausgebildet werden, daß weder Transportband noch Transportgegenstand beschädigt werden, und viertens muß die Trennung der Verbindung ohne größeren Aufwand, schnell und rückstandsfrei am Bestimmungsort vorgenommen werden können.

DE 101 11 038 beschreibt ein Verbundmaterial, das ein einfaches und problemloses Anbringen und ein rückstandsfreies Wiederentfernen eines Aufklebers auf bzw. von einem Gegenstand ermöglicht. Es wird ein Verbundmaterial mit einer Trägerschicht und einer Haftfolie beschrieben, wobei die nicht-haftfähige Oberseite der Haftfolie zumindest partiell bedruckbar ist und die haftfähige Unterseite der Haftfolie auf der Oberseite der Trägerschicht lösbar angeordnet ist. Die Ober- und Unterseite der Haftfolie können aus zwei co-extrudierten oder über ein Verbindungsmittel miteinander kaschierten Kunststoffschichten bestehen.

JP 2002 0456834 beschreibt ein Förderband mit Harzschichten auf der Ober- und Unterseite, unter diesen Harzschichten angeordnete Kernschichten und einer zwischen den Kernschichten angeordneten Klebstoffschicht.

JP 2004 136568 betrifft ein klebriges Gummiband, das aufgrund seines weichen Gummimaterials Haftungseigenschaften aufweist, so dass Gegenstände, die bedruckt werden sollen, lösbar darauf gehalten werden können, ohne dass bei deren Entfernung klebriges Material darauf zurückbleibt.

US 4,927,709 beschreibt ein wärmeübertragbares Etikett mit einer Trägerschicht aus Papier und einem darauf befestigten wärmeübertragbaren Substrat. Das wärmeübertragbare Substrat weist eine Lackübertragungsschicht, eine darüber angeordnete, farbig gestaltete Schicht und eine wiederum darüber angeordnete, wärmeaktivierbare Haftschicht auf.

Aus dem Stand der Technik sind Transportbänder bekannt, die aus bandförmigen Polymerfolien bestehen. Auf diesen Folienbändern sind in vorgegebenen Abständen Klebstoffstellen oder einseitig eine kontinuierliche Klebstoffschicht vorgesehen. Üblicherweise sind entlang der Längskanten dieser Transportbänder Einstanzungen vorgesehen, in die zu Führungs- und Antriebszwecken Zahnräder passend eingreifen. Die Einstanzungen dienen häufig auch einer gewissen Materialersparnis und Gewichtsreduzierung. Gleichzeitig sind diese Einstanzungen bei den üblichen Folientransportbändern aber auch eine Schwachstelle, da es von diesen Einstanzungen ausgehend leicht zu Einrissen in das Transportbandmaterial kommen kann, die sich dann durch das Material fortsetzen und zu einem Abriß des Bandes führen können. Solche Ereignisse sind selbstverständlich unbedingt zu vermeiden, da hierdurch in der Regel der gesamte Produktionsprozeß unterbrochen wird.

Bei den aus dem Stand der Technik bekannten Folientransportbändern kommt es dennoch häufig zu diesen Ereignissen, da in der Regel mit sehr hohen Transportgeschwindigkeiten gearbeitet wird, wodurch das Folienmaterial sehr stark beansprucht wird. Außerdem sind die üblichen Folientransportbänder in der Regel nicht elastisch, d.h. nicht dehnbar, da dehnbare Folienbänder nur schwer über Rollensysteme kontrolliert und gleichmäßig gespannt geführt werden können. Daher werden üblicherweise biaxial orientierte Folienbänder verwendet, die über ihre Dehngrenze hinaus biaxial gereckt wurden.

Durch das Recken von Polymerfolien werden die Molekülketten in Reckrichtung monoaxial bzw. biaxial orientiert. Hierdurch nimmt die Foliendehnbarkeit auf ein Minimum ab. Die biaxial orientierten Folien haben eine sehr hohe Einreißkraft, sind sie jedoch an einer Stelle bereits eingerissen, so weisen sie nur einen sehr geringen Weiterreißwiderstand auf, d.h. daß sich bestehende Risse sehr schnell und sehr leicht über das Folienmaterial fortpflanzen können, was in der Regel zu einem Abriß des Transportbandes führt.

Es besteht daher ein Bedarf nach Transportfolien, mit denen Transportgegenstände lösbar verbindbar sind und die bei hohen Transportgeschwindigkeiten über Rollensysteme unter Zugspannung nicht einreißen, auch dann nicht, wenn auf dem Band Einstanzungen vorgesehen sind. Es besteht also insbesondere ein Bedarf nach Haftfolien mit geringer Dehnbarkeit und hoher primärer Reißfestigkeit sowie hoher Weiterreißfestigkeit. Weiterhin soll eine Haftfolie, die die vorgenannten Merkmale aufweist, auch von möglichst geringem Gewicht sein.

Es ist daher die Aufgabe der vorliegenden Erfindung, eine Haftfolie mit geringer Dehnbarkeit, hoher Reiß- sowie Weiterreißfestigkeit und möglichst geringem Gewicht bereitzustellen, an die Transportgegenstände vorübergehend angeheftet werden können und mit der diese Transportgegenstände mit hoher Geschwindigkeit transportiert werden können.

Diese Aufgabe wird erfindungsgemäß gelöst durch eine Haftfolie zum lösbaren Halten von Gegenständen, die dadurch gekennzeichnet ist, daß sie zumindest eine Trägerschicht aus einem ersten Polymermaterial aufweist, die wenigstens in einer Richtung X um höchstens 50 % dehnbar ist, und eine Haftschicht aus einem zweiten, nicht-siegelfähigen Polymermaterial aufweist, die wenigstens in der Richtung X stärker dehnbar als die Trägerschicht ist.

Die erfindungsgemäße Haftfolie ist eine Mehrschichtfolie bzw. ein Folienlaminat aus wenigstens zwei voneinander verschiedenen Schichten, von denen eine eine primär tragende, stabilitätsverleihende Funktion hat (Trägerschicht) und die andere primär dazu dient, eine Verbindung zwischen Haftfolie und Transportgegenstand auszubilden (Haftschicht). Die Haftschicht der erfindungsgemäßen Folie hat jedoch noch eine zweite bedeutende Funktion, nämlich die der Verbesserung der Weiterreißfestigkeit des Folienlaminats. Durch die in einer gegebenen Richtung X höhere Dehnbarkeit des Polymermaterials der Haftschicht im Vergleich zu der relativ geringen Dehnbarkeit von höchstens 50 % der Trägerschicht in dieser Richtung wird die Reißfestigkeit und insbesondere die Weiterreißfestigkeit der Haftfolie gegenüber einer Folie, die nur aus relativ wenig dehnbarem Polymermaterial besteht, deutlich verbessert.

Unter dem Begriff "Folien" werden hier bahnförmig vorliegende Materialien verstanden, die vorzugsweise wenige Millimeter dick sind, besonders bevorzugt unter 1 mm Dicke aufweisen. Die erfindungsgemäße Haftfolie weist verschiedene Schichten auf, wobei die Schichten vorzugsweise selbst in Form von Folien vorliegen. Daher umfassen die Begriffe "Trägerschicht" bzw. "Haftschicht" jeweils auch die Begriffe "Trägerschichtfolie" bzw. "Haftschichtfolie". Sowohl Träger- als auch Haftschicht können in der Haftfolie jedoch auch nicht-folienartig vorgesehen sein, z.B. wenn bei der Herstellung eine der beiden Schichten auf die andere, folienartig vorliegende Schicht aufgetragen wird.

Bevorzugt sind Ausführungsformen, mit einer relativ geringen Dehnbarkeit des Polymermaterials der Trägerschicht, damit diese Folien mit Vorteil in Form von Folienbändern verwendbar sind, die kontrolliert und gleichmäßig gespannt über Rollensysteme geführt werden sollen. So beträgt bei bevorzugten Ausführungsformen die Dehnbarkeit der Trägerschicht wenigstens in der Richtung X höchstens 30 % und bei besonders bevorzugten Ausführungsformen höchstens 15 %. Treten bei der bestimmungsgemäßen Verwendung besonders hohe Zugkräfte auf, so ist eine Dehnbarkeit von höchstens 3 % bevorzugt, wobei bei speziellen Ausführungsformen eine Dehnbarkeit von höchstens 1 % bevorzugt wird.

Besonders bevorzugt sind auch Ausführungsformen, bei denen die Trägerschicht wenigstens in der Richtung X um wenigstens 1 % dehnbar ist, vorzugsweise um wenigstens 3 % dehnbar ist, da eine gewisse Mindestdehnbarkeit von Vorteil sein kann, wenn ruckartig auftretende Zugkräfte aufzunehmen sind, beispielsweise beim Starten eines Transportbandes. So sind spezielle Ausführungsformen dadurch gekennzeichnet, daß die Dehnbarkeit der Trägerschicht im Bereich von 1 bis 30 % liegt. Des weiteren sind Ausführungsformen bevorzugt, bei denen die Dehnbarkeit der Trägerschicht im Bereich von 1 bis 15 % oder im Bereich von 1 bis 3 % liegt.

Die in den letzten beiden Absätzen genannten Ausführungsformen sind insbesondere dann bevorzugt, wenn sie für Anwendungen bestimmt sind, bei denen die erfindungsgemäße Haftfolie in Form von Folienbändern verwendet werden soll, die mit hohen Bandlaufgeschwindigkeiten eingesetzt werden und/oder die bei bestimmungsgemäßem Gebrauch starken Zugkräften ausgesetzt sind.

Vorzugsweise ist die Dehnbarkeit der Haftschicht etwa doppelt so hoch wie die der Trägerschicht. Besonders bevorzugt ist die Dehnbarkeit der Haftschicht etwa 3- bis 10-mal höher als die der Trägerschicht. Bei speziellen besonders bevorzugten Ausführungsformen ist die Haftschicht etwa 5- bis 7-mal dehnbarer als die Trägerschicht.

Die Haftschicht besteht erfindungsgemäß aus einem nicht siegelfähigen Polymermaterial, vorzugsweise einer nicht siegelfähigen Polymerfolie. Eine Polymerfolie ist siegelfähig, wenn sie beim Verschweißen mit sich selbst oder mit anderen Materialien so verschmilzt, daß die hierdurch entstandene Verbindung nicht wieder getrennt werden kann, ohne das siegelfähige Material zu verletzen. Bei einer Verbindung dieser Art spricht man auch von einer sogenannten Festversiegelung. Dagegen ist die Verbindung eines nicht siegelfähigen Materials mit sich selbst oder mit einem anderen Material, beispielsweise durch Verschweißen, ohne weiteres wieder so trennbar, daß das nicht-siegelfähige Material nicht verletzt wird. Das heißt, daß in das nicht siegelfähige Material Gegenstände eingebettet werden und daran anhaften können, wobei diese Gegenstände von dem nicht siegelfähigen Material wieder abgeschält werden können, ohne daß das nicht siegelfähige Material hierdurch verletzt oder gar zerstört wird. Bei einer Verbindung dieser Art spricht man auch von einer peelfähigen Verbindung.

Anders formuliert umfaßt die erfindungsgemäße Haftfolie also zum einen eine Trägerschicht mit einer geringen Dehnbarkeit, wobei die Trägerschicht aus siegelfähigem (fest siegelndem) oder peelfähigem Polymer bestehen kann, und zum anderen eine Haftschicht aus peelfähigem (nicht festsiegelndem) Polymer, die auf die Trägerschicht aufgeschichtet ist, und die stärker dehnbar als die Trägerschicht ist.

Vorzugsweise ist die Abschälkraft, die aufgewendet werden muß, um an der Haftschicht befestigte Gegenstände von dieser wieder abzulösen, niedriger als die Reißfestigkeit der Trägerfolie. Weiterhin ist bevorzugt, daß die Abschälkraft, die aufgewendet werden muß, um an der Haftschicht befestigte Gegenstände von dieser wieder abzulösen, auch geringer als die Haftkraft zwischen Haftschicht und Trägerschicht ist.

Bei einer bevorzugten Ausführungsform der vorliegenden Erfindung ist die Haftschicht derart ausgebildet, daß sie durch Temperaturerhöhung, Inkontaktbringen mit den Transportgegenständen und durch die anschließende Abkühlung so fest mit den Transportgegenständen verbindbar ist, daß die Transportgegenstände einwandfrei transportiert werden können und an ihrem Bestimmungsort von der Haftschicht wieder abgeschält werden können. Bei dieser Ausführungsform wird die Verbindung zwischen Transportgegenständen und Haftfolie also dadurch ausgebildet, daß in dem Bereich, in dem die Verbindung ausgebildet werden soll, wenigstens das Polymermaterial der Haftschicht auf eine erhöhte Temperatur gebracht wird. Hierdurch wird das Polymermaterial der Haftschicht etwas weicher, so daß die Transportgegenstände in die nunmehr weichere Polymermatrix der Haftschicht besser eingedrückt werden können, wodurch sie so mit der Haftschicht verbunden werden, daß sie von dieser an der Transportfolie gehalten werden, sobald nach der Ausbildung des Kontakts zwischen Haftschicht und Transportgegenstand sich die Temperatur der Haftschicht wieder abgesenkt. Der auf diese Weise mit der Haftfolie verbundene Transportgegenstand kann dann ohne weiteres an seinem Bestimmungsort leicht wieder von der Haftfolie entfernt werden. Bei einer speziellen Ausführungsform der Erfindung wird die Verbindung zwischen Transportgegenständen und Haftschicht erst dadurch wieder lösbar, daß die Temperatur der Haftschicht am Bestimmungsort oder kurz davor erneut erhöht wird.

Üblicherweise wird die Erhöhung der Temperatur der Haftschicht aus der Richtung erfolgen, in die die Haftschicht der Haftfolie weist. Allerdings kann die Temperaturerhöhung auch von der gegenüberliegenden Seite der Haftfolie erfolgen, beispielsweise durch eine Siegelbacke, die an der Trägerschicht der Haftfolie anliegt. Daher ist es bei einigen Ausführungsformen der vorliegenden Erfindung bevorzugt, daß die Vicat-Erweichungstemperatur der Trägerschicht höher als die Vicat-Erweichungstemperatur der Haftschicht ist, da bei der Temperaturerhöhung durch die Trägerschicht hindurch die Trägerschicht sonst selbst zu stark erweicht würde, was zu einer unerwünschten Kräuselung oder Schrumpfung der Trägerschicht führen kann. Hierbei ist die Vicat-Erweichungstemperatur die Temperatur, bei der in eine zunehmend erwärmte Polymerprobe ein definiert belasteter Stahlstift von 1 mm² Querschnitt 1 mm tief eindringt.

Besonders bevorzugt wird die Dehnbarkeit der Trägerschicht verringert, indem das Polymermaterial dieser Schicht orientiert wird. Dementsprechend besteht die Trägerschicht vorzugsweise aus monoaxial orientiertem Polymermaterial und besonders bevorzugt aus biaxial orientiertem Polymermaterial. Da die Haftschicht eine höhere Dehnbarkeit als die Trägerschicht aufweisen soll, besteht sie vorzugsweise aus nicht orientiertem Polymermaterial. Bei einigen Ausführungsformen ist das Polymermaterial der Haftschicht jedoch monoaxial, aber nicht biaxial orientiert.

Die für die Trägerschicht vorzugsweise verwendeten Polymermaterialien umfassen Polypropylen oder Polyester. Ein besonders bevorzugtes Trägerschichtpolymer ist Polyethylenterephthalat. Die Haftschicht besteht vorzugsweise aus Polyethylen, Polypropylen oder Ethylen-Vinylacetat-Copolymer.

Die Schichtdicke der Trägerschicht beträgt bei besonders bevorzugten Ausführungsformen 10-100 µm. Besonders bevorzugt sind Ausführungsformen mit einer Trägerschichtdicke von 20-80 µm. Allgemein gilt der Grundsatz, daß die Schichtdicke stets so gering wie möglich zu wählen ist, um das Gewicht der Transportfolie insgesamt möglichst gering zu halten. Hierzu ist jedoch anzumerken, daß höhere Trägerschichtdicken insbesondere dann von Vorteil sind, wenn die Temperaturerhöhung durch die Trägerschicht hindurch erfolgt, z.B. wenn eine Siegelbacke "von hinten" an die Haftfolie (an der Außenfläche der Trägerschicht) anliegt. Da die Wärmeapplikation durch diese Trägerschicht bei zu geringen Schichtdicken der Trägerschicht zu Verformungen führen kann, ist es in diesem Fall vorteilhaft, wenn die Schichtdicke wenigstens 50 µm beträgt. Unterhalb von etwa 10 µm ist die Reißfestigkeit der Trägerschicht für viele Anwendungen nicht mehr hoch genug, so daß es bevorzugt ist, daß die Trägerschichtdicke wenigstens 10 µm beträgt. Besonders gute Reißfestigkeit-Schichtdicken-Verhältnisse sind für Trägerschichtdicken von 20-80 µm festgestellt worden. Schichtdicken von 80-100 µm sind dann vorteilhaft, wenn eine Färbung der Haftfolie gewünscht ist. Eine Färbung der Haftfolie kann aus ästhetischen Gründen gewünscht sein oder auch erforderlich sein, wenn die Steuerung der Transportfolie durch Photozellen erfolgt, die das Band optisch erkennen müssen, um dessen ordnungsgemäßen Lauf kontrollieren und entsprechend steuern zu können.

Die Haftschichtdicke beträgt bei speziellen Ausführungsformen der vorliegenden Erfindung 20-80 µm. Bei besonders bevorzugten Ausführungsformen beträgt die Dicke der Haftschicht 30-50 µm.

Auch für die Haftschicht gilt der Grundsatz der möglichst geringen Schichtdicke. Es gilt jedoch auch, daß die Dicke der Haftschicht in jedem Fall hoch genug sein muß, damit sie die erforderliche Reißfestigkeit und/oder Weiterreißfestigkeit verleiht. Des weiteren muß die Dicke der Haftschicht hoch genug sein, damit sich die Transportgegenstände so in den Folienschichtkörper einbetten können, daß sie von der Haftschicht bei gegebener Transportgeschwindigkeit fest genug gehalten werden.

Die Haftfolien der vorliegenden Erfindung können durch Coextrusion hergestellt werden, z.B. mit Blaswerkzeugen für Zweischichtfolien oder mit Mehrschichtwerkzeugen, bei denen zwei unterschiedlich temperierte Schmelzströme kurz vor dem Austritt zusammengeführt werden. Die erfindungsgemäßen Folienlaminate können aber auch durch Post-Coextrusionsverfahren erhalten werden, bei denen auf eine frisch hergestellte einschichtige Folie das Material der zweiten Folienschicht aufextrudiert wird. Darüber hinaus kann das Material einer zweiten Folienschicht auch durch das Aufstreichen mit einem Rakel auf die erste Folienschicht oder durch das Aufschichten mit Walzen erhalten werden. Außerdem können zwei bestehende Folien auch durch Kalandrierung miteinander kaschiert werden.

Bei besonders bevorzugten Ausführungsformen der vorliegenden Erfindung wird zur Verbindung der beiden Folienschichten eine Schicht Polymerklebstoff zwischen Trägerschicht und Haftschicht vorgesehen. Die Schichtdicke dieser Polymerklebstoffschicht beträgt vorzugsweise 0,5-5 µm. Besonders bevorzugt sind Polymerklebstoffschichten mit einer Dicke von 1-3 µm.

Vorzugsweise ist der Polymerklebstoff dazu geeignet, die Festigkeit der Verbindung zwischen Trägerschicht und Haftschicht so zu erhöhen, daß diese Verbindung der Kraft, die zum Abschälen der Transportgegenstände angewandt wird, besser standhält. Besonders bevorzugt wird durch den Polymerklebstoff eine feste, nicht mehr lösbare Verbindung zwischen Träger- und Haftschicht hergestellt.

Die erfindungsgemäßen Haftfolien sind zum Transport der verschiedensten Gegenständen geeignet. Insbesondere sind die erfindungsgemäßen Haftfolien für den Transport von relativ leichten Komponenten in einem Fertigungsprozeß geeignet. Bevorzugte Ausführungsformen der erfindungsgemäßen Haftfolie sind beispielsweise lösbar mit Gegenständen verbindbar oder verbunden, die unter Mikrochips, Aufdruckantennen, Etiketten, Emblemen, Schlaufen und Bändern ausgewählt sind.

Besonders bevorzugt ist es, wenn eine Haftfolie gemäß der vorliegenden Erfindung Bestandteil eines Transportbandes zum Transportieren von Gegenständen ist, wobei hier unter einem Transportband ein Band verstanden wird, das beispielsweise über Rollen angetrieben mit relativ hoher Geschwindigkeit entweder in einem Kreislauf oder lediglich in eine Richtung fortbewegt wird. Ist die Haftfolie Bestandteil eines Transportbandes, so besteht die Trägerschicht der Haftfolie aus Polymermaterial, das wenigstens in Längsrichtung des Transportbandes orientiert ist. Entsprechend besteht die Haftschicht dieser Folie vorzugsweise aus einem Polymermaterial, das wenigstens in Längsrichtung des Transportbandes nicht orientiert ist.

Es wird darauf hingewiesen, daß sämtliche Merkmale, wie sie sich aus der vorliegenden Beschreibung und den Ansprüchen für einen Fachmann erschließen, sowohl einzeln als auch in beliebigen Zusammenstellungen mit anderen der hier offenbarten Merkmale oder Merkmalsgruppen kombinierbar sind, soweit dies nicht ausdrücklich ausgeschlossen wurde oder derartige Kombinationen technisch unmöglich oder sinnlos wären. Dies gilt auch, wenn die einzelnen Merkmale oder Merkmalsgruppen konkret nur im Zusammenhang mit bestimmten weiteren Merkmalen beschrieben wurden. Auf die umfassende Darstellung sämtlicher denkbarer Merkmalskombinationen wird hier nur der Kürze und der Lesbarkeit der Beschreibung wegen verzichtet. Beispielhaft ergeben sich aber einige solcher Merkmalskombinationen sowie weitere Vorteile, Merkmale und Anwendungsmöglichkeiten der vorliegenden Erfindung aus den folgenden Beispielen.

### Beispiel 1

Im Rahmen eines Herstellungsverfahrens für Wurstwaren sollten an einem Ende jeder Wurst eine Schlaufe zum Aufhängen angebracht werden. Der Fördertakt betrug 150 Würste pro Minute, d.h. dass entsprechend 150 Schlaufen pro Minute zur Anbringung an den Wurstenden bereitgestellt werden mussten. Diese Bereitstellung erfolgte durch ein Folienband, an dem die Wurstschlaufen in vorgegebenen Abständen vorgesehen waren. Am entsprechenden Verarbeitungsort der Produktionsanlage sollten die Schlaufen automatisch zügig vom Transportband entnommen werden und an den Wurstenden durch Verknoten befestigt werden.

Hierfür wurde eine erfindungsgemäße Haftfolie als Transportband verwendet, wobei die Trägerschicht aus biaxial gerecktem und damit biaxial orientiertem PET (Polyethylenterephthalat) und die Haftfolie aus nicht-orientierter (ungereckter), nicht-siegelfähiger Polypropylenfolie (UPP) bestand. Die Dehnbarkeit der Trägerschicht betrug in Längsrichtung des Transportbandes höchstens etwa 50%, wobei das Transportband in Längsrichtung um etwa 3 % der ursprünglichen Länge (entspanntes Transportband) gedehnt werden konnte, ohne dass das Material riss. Die Haftschicht wies eine Dehnbarkeit von etwa 300 % auf. Der Schmelzpunkt des Trägerschichtpolymers lag bei 260°C und dessen Vicat-Erweichungspunkt bei 120°C. Der Schmelzpunkt des Haftschichtpolymers lag bei 160°C und dessen Vicat-Erweichungspunkt bei 90°C. Die Schichtdicke der Trägerschicht betrugt 23 µm und die der Haftschicht betrug 40 µm. Zwischen Träger- und Haftfolie befand sich eine Kaschierklebstoffschicht mit einer Schichtdicke von 1 µm. Die Schlaufen bestanden aus Polypropylen und wurden quer zur Laufrichtung des Transportbandes bei einer Applikationstemperatur von etwa 110°C in die Haftschicht eingepresst.

Im Betrieb konnte für das oben beschriebene Folienband gezeigt werden, dass bei einer Taktzahl von 150 Würsten, die pro Minute mit einer Schlaufe versehen wurden, und bei einer Gesamttestzeit von 24 Stunden das Folienband einwandfrei über das Rollensystem geführt wurde und kein Abriss des Folienbandes auftrat.

### Beispiel 2

Die Versuchsbedingungen für Beispiel 2 waren mit denen von Beispiel 1 weitestgehend gleich, außer dass die Schichtdicke der Trägerschicht 75 µm betrug. Die Trägerschichtdicke wurde in diesem Beispiel etwas größer gewählt, da die Siegelbacke zur Erwärmung der Haftfolie bei der Anheftung der Wurstschlaufen an die Haftfolie während der Verarbeitung "von hinten" angriff. Das heißt in diesem Beispiel lag die Siegelbacke auf der freien Außenfläche der Trägerschicht an, so dass die Temperatur durch die Trägerschicht hindurch auf die Haftschicht übertragen wurde, um das Haftschichtpolymer zur Entnahme der Schlaufen aufzuweichen.

In der Anwendung wurde festgestellt, daß das eingesetzte Folienband über 24 Stunden einwandfrei über das Rollensystem geführt wurde, ohne daß es zu Einrissen bzw. Abrissen des Transportbandes kam. Im Gegensatz dazu war der Einsatz einer Transportfolie gemäß Beispiel 1 nicht zufriedenstellend, da durch die schnellere Erwärmung der dünneren Trägerschicht der Haftfolie gemäß Beispiel 1 die Haftfolie "unruhig" wurde, d.h. daß die Folie Schrumpfungen und Kräuselungen in der Trägerschicht aufwies. Diese Transportfolie war daher nicht einsetzbar.

### Beispiel 3

Auch in Beispiel 3 wurde eine Haftfolie als Transportband eingesetzt, die den Grundaufbau der in Beispiel 1 beschriebenen Haftfolie aufwies. Die Haftfolie gemäß diesem Beispiel unterschied sich von der Haftfolie aus Beispiel 1 lediglich darin, daß die Haftschicht eine Dicke von 60 µm aufwies und daß die Schlaufen aus Hanffasern bestanden. Die Hanffaserschlaufen wiesen eine etwas größere Stärke auf als die Polypropylenschlaufen aus Beispiel 1. Daher war die Haftfestigkeit der Hanfschlaufen auf der Haftfolie gemäß Beispiel 1 nicht zufriedenstellend, d.h. einzelne Hanfschlaufen lösten sich während des Transports spontan von der Haftschicht und standen somit am Bestimmungsort nicht zur Verarbeitung zur Verfügung. Dagegen wies die etwas dickere Haftschicht gemäß Beispiel 3 deutlich bessere Haftfestigkeit in Verbindung mit den Hanfschlaufen auf, so daß beinahe eine einwandfreie Verarbeitung möglich war. Lediglich vereinzelt kam es noch zu spontanem Ablösen der Schlaufen aus der Haftschicht. Dies konnte jedoch dadurch behoben werden, daß die Schlaufen vollflächig mit der Haftschicht in Kontakt gebracht wurden, indem die Schlaufen in Längsrichtung des Transportbandes ausgerichtet wurden.

## Patentansprüche

1. Haftfolie zum lösbaren Halten von Gegenständen, wobei die Haftfolie zumindest eine Trägerschicht aus einem ersten Polymermaterial aufweist und eine Haftschicht aus einem zweiten Polymermaterial aufweist, **dadurch gekennzeichnet, daß** die Trägerschicht wenigstens in einer Richtung X eine Dehnbarkeit in dem Bereich von 1 bis 3 % aufweist und die Haftschicht aus einem nicht siegelfähigem Polymermaterial ist und wenigstens in der Richtung X stärker dehnbar als die Trägerschicht ist.

2. Haftfolie nach Anspruch 1, **dadurch gekennzeichnet, daß** die Haftschicht etwa 2- bis 10-mal dehnbarer als die Trägerschicht ist, vorzugsweise 3- bis 7-mal und besonders bevorzugt 5- bis 7-mal dehnbarer.

3. Haftfolie nach einem der Ansprüche 1 oder 2, **dadurch gekennzeichnet, daß** die Haftschicht derart ausgebildet ist, daß sie durch Temperaturerhöhung, Inkontaktbringen mit den Gegenständen und anschließende Abkühlung fest mit den Gegenständen verbindbar ist, wobei diese Verbindung wieder lösbar ist.

4. Haftfolie nach einem der Ansprüche 1 bis 3, **dadurch gekennzeichnet, daß** die Vicat-Erweichungstemperatur der Trägerschicht höher als die Vicat-Erweichungstemperatur der Haftschicht ist.

5. Haftfolie nach einem der Ansprüche 1 bis 4, **dadurch gekennzeichnet, daß** die Trägerschicht aus monoaxial, vorzugsweise biaxial orientiertem Polymermaterial besteht.

6. Haftfolie nach einem der Ansprüche 1 bis 5, **dadurch gekennzeichnet, daß** die Trägerschicht aus Polypropylen oder Polyester besteht.

7. Haftfolie nach einem der Ansprüche 1 bis 6, **dadurch gekennzeichnet, daß** die Haftschicht aus höchstens monoaxial orientiertem Polymermaterial besteht.

8. Haftfolie nach einem der Ansprüche 1 bis 7, **dadurch gekennzeichnet, daß** die Haftschicht aus Polyethylen, Polypropylen oder Ethylen-Vinylacetat-Copolymer besteht.

9. Haftfolie nach einem der Ansprüche 1 bis 8, **dadurch gekennzeichnet, daß** die Schichtdicke der Trägerschicht 10 bis 100 µm beträgt, vorzugsweise 20 bis 80 µm beträgt.

10. Haftfolie nach einem der Ansprüche 1 bis 9, **dadurch gekennzeichnet, daß** die Schichtdicke der Haftschicht 20 bis 80 µm beträgt, vorzugsweise 30 bis 50 µm beträgt.

11. Haftfolie nach einem der Ansprüche 1 bis 10, **dadurch gekennzeichnet, daß** sie zwischen Trägerschicht und Haftschicht eine Schicht Polymerklebstoff aufweist, wobei die Schichtdicke der Polymerklebstoffschicht vorzugsweise 0,5 bis 5 µm beträgt, besonders bevorzugt, 1 bis 3 µm beträgt.

12. Haftfolie nach einem der Ansprüche 1 bis 11, **dadurch gekennzeichnet, daß** sie lösbar mit Gegenständen verbindbar oder verbunden ist, die unter Mikrochips, Aufdruckantennen, Etiketten, Emblemen, Schlaufen und Bändern ausgewählt sind.

13. Transportband zum Transportieren von Gegenständen, wobei die Gegenstände lösbar mit dem Transportband verbunden oder verbindbar sind, **dadurch gekennzeichnet, daß** das Transportband eine Haftfolie nach einem der Ansprüche 1 bis 12 aufweist.

14. Transportband nach Anspruch 13, **dadurch gekennzeichnet, daß** die Trägerschicht der Haftfolie aus wenigstens in Längsrichtung des Transportbandes orientiertem Polymermaterial besteht.

15. Transportband nach einem der Ansprüche 13 oder 14, **dadurch gekennzeichnet, daß** die Haftschicht der Haftfolie aus wenigstens in Längsrichtung des Transportbandes nichtorientiertem Polymermaterial besteht.

## Claims

1. Adhesive film for releasably holding articles, wherein the adhesive film has at least one carrier layer comprising a first polymer material and an adhesive layer comprising a second polymer material **characterized in that** the carrier layer has a stretchability in the range of 1 to 3 % at least in a direction X, and that the adhesive layer is made of a non-sealable polymer material and has a higher stretchability than the carrier layer at least in the direction X.

2. Adhesive film according to claim 1, **characterized in that** the adhesive layer is about 2 to 10 times more stretchable than the carrier layer, preferably 3 to 7 times more stretchable and particularly preferred 5 to 7 times more stretchable.

3. Adhesive film according to one of the claims 1 or 2, **characterized in that** the adhesive layer is made in such a way that it can be fixedly connected to the articles by increasing the temperature, bringing in contact with the articles and subsequent cooling, wherein said connection is releasable.

4. Adhesive film according to one of the claims 1 to 3, **characterized in that** the Vicat softening temperature of the carrier layer is higher than the Vicat softening temperature of the adhesive layer.

5. Adhesive film according to one of the claims 1 to 4, **characterized in that** the carrier layer comprises monoaxially oriented, preferably biaxially oriented, polymer material.

6. Adhesive film according to one of the claims 1 to 5, **characterized in that** the carrier layer comprises polypropylene or polyester.

7. Adhesive film according to one of the claims 1 to 6, **characterized in that** the adhesive layer comprises at most monoaxially-oriented polymer material.

8. Adhesive film according to one of the claims 1 to 7, **characterized in that** the adhesive layer comprises polyethylene, polypropylene or ethylene-vinyl-acetate-copolymer.

9. Adhesive film according to one of the claims 1 to 8, **characterized in that** the layer thickness of the carrier layer is between 10 and 100 µm, preferably between 20 and 80 µm.

10. Adhesive film according to one of the claims 1 to 9, **characterized in that** the layer thickness of the adhesive layer is between 20 and 80 µm, preferably between 30 and 50 µm.

11. Adhesive film according to one of the claims 1 to 10, **characterized in that** it comprises a layer of polymer adhesive between the carrier layer and the adhesive layer, wherein the layer thickness of the polymer adhesive layer is preferably 0,5 to 5 µm, particularly preferred 1 to 3 µm.

12. Adhesive film according to one of the claims 1 to 11, **characterized in that** it is or can be releasably connected to articles which are selected from microchips, printed antennas, labels, emblems, loops and tapes.

13. Conveyor belt for conveying articles, wherein the articles are or can be releasably connected to the conveyor belt, **characterized in that** the conveyor belt has an adhesive film according to one of the claims 1 to 12.

14. Conveyor belt according to claim 13, **characterized in that** the carrier layer of the adhesive film comprises polymer material which is oriented at least in the longitudinal direction of the conveyor belt.

15. Conveyor belt according to one of the claims 13 or 14, **characterized in that** the adhesive layer of the adhesive film comprises polymer material which is non-oriented at least in the longitudinal direction of the conveyor belt.

## Revendications

1. Film adhésif pour le maintien amovible d'objets, le film adhésif présentant au moins une couche porteuse en une première matière polymère et une couche adhésive en une deuxième matière polymère, **caractérisé en ce que** la couche porteuse présente au moins une extensibilité de l'ordre de 1 à 3 % dans une direction X et **en ce que** la couche adhésive est en une matière polymère non scellable et au moins dans la direction X est plus fortement extensible que la couche porteuse.

2. Film adhésif selon la revendication 1, **caractérisé en ce que** la couche adhésive est entre 2 et 10 fois plus extensible que la couche porteuse, de préférence 3 à 7 fois et en particulier de préférence 5 à 7 fois plus extensible.

3. Film adhésif selon l'une des revendications 1 ou 2, **caractérisé en ce que** la couche adhésive est constituée de manière à pouvoir être fixée aux objets par augmentation de température, mise en contact avec les objets et refroidissement consécutif, cette fixation étant encore amovible.

4. Film adhésif selon l'une des revendications 1 à 3, **caractérisé en ce que** la température de ramollissement de Vicat de la couche porteuse est plus élevée que la température de ramollissement de Vicat de la couche adhésive.

5. Film adhésif selon l'une des revendications 1 à 4, **caractérisé en ce que** la couche porteuse est en matière polymère à orientation mono-axiale, de préférence bi-axiale.

6. Film adhésif selon l'une des revendications 1 à 5, **caractérisé en ce que** la couche porteuse est en polypropylène ou polyester.

7. Film adhésif selon l'une des revendications 1 à 6, **caractérisé en ce que** la couche adhésive est en matière polymère à orientation tout au plus mono-axiale.

8. Film adhésif selon l'une des revendications 1 à 7, **caractérisé en ce que** la couche adhésive est en polyéthylène, polypropylène ou copolymère d'éthylène-acétate de vinyle.

9. Film adhésif selon l'une des revendications 1 à 8, **caractérisé en ce que** l'épaisseur de la couche porteuse mesure de 10 à 100 µm, de préférence 20 à 80 µm.

10. Film adhésif selon l'une des revendications 1 à 9, **caractérisé en ce que** l'épaisseur de la couche adhésive mesure de 20 à 80 µm, de préférence 30 à 50 µm.

11. Film adhésif selon l'une des revendications 1 à 10, **caractérisé en ce qu'**il présente une couche de colle polymère entre couche porteuse et couche adhésive, l'épaisseur de la couche de colle polymère mesurant de 0,5 à 5 µm, en particulier de préférence 1 à 3 µm.

12. Film adhésif selon l'une des revendications 1 à 11, **caractérisé en ce qu'**il peut être ou est fixé de façon amovible à des objets choisis parmi des micro-puces, antennes à pression, étiquettes, emblèmes et bandes.

13. Bande transporteuse pour le transport d'objets, les objets étant ou pouvant être fixés de façon amovible à la bande transporteuse, **caractérisée en ce que** la bande transporteuse présente un film adhésif selon l'une des revendications 1 à 12.

14. Bande transporteuse selon la revendication 13, **caractérisée en ce que** la couche porteuse du film adhésif est en matière polymère pour le moins orientée dans le sens longitudinal de la bande transporteuse.

15. Bande transporteuse selon la revendication 13 ou 14, **caractérisée en ce que** la couche adhésive du film adhésif est en matière polymère pour le moins non orientée dans le sens longitudinal de la bande transporteuse.
